# EUROPÄISCHE PATENTANMELDUNG

(11) **EP 3 787 041 A1**
(43) Veröffentlichungstag der Anmeldung: **03.03.2021**
(21) Anmeldenummer: 20000291.3
(22) Anmeldetag: 17.08.2020
(51) Int. Cl.: H01L 31/0687, H01L 31/0224, H01L 31/0216

(54) **STAPELFÖRMIGE MEHRFACHSOLARZELLE MIT EINER EIN MEHRFACHSCHICHTSYSTEM UMFASSENDEN METALLISIERUNG**

(30) Priorität: 29.08.2019 DE 102019006099
(71) Anmelder: AZUR SPACE Solar Power GmbH, 74072 Heilbronn (DE)
(72) Erfinder: Köstler, Wolfgang, 74074 Heilbronn (DE); Hagedorn, Benjamin, 74248 Ellhofen (DE)
(74) Vertreter: Koch Müller Patentanwaltsgesellschaft mbH

(57) **Zusammenfassung**

Stapelförmige Mehrfachsolarzelle mit einer ein Mehrschichtsystem umfassenden Metallisierung, wobei die Mehrfachsolarzelle ein eine Unterseite der Mehrfachsolarzelle ausbildendes Germanium-Substrat, eine Germanium-Teilzelle und mindestens zwei III-V-Teilzellen aufweist, das Mehrschichtsystem der Metallisierung eine Gold und Germanium umfassende erste Schicht mit einer Schichtdicke D1 von mindestens 2 nm und höchstens 50 nm, eine Titan umfassende zweite Schicht mit einer Dicke D2 von mindestens 10 nm und höchstens 300 nm, eine Palladium oder Nickel oder Platin umfassende dritte Schicht mit einer Schichtdicke D3 und mindestens eine metallische vierte Schicht mit einer Dicke D4 von mindestens 2 µm in der genannten Reihenfolge aufweist und das Mehrschichtsystem der Metallisierung zumindest einen ersten und zweiten Oberflächenabschnitt bedeckt und mit dem ersten und zweiten Oberflächenabschnitt stoffschlüssig verbunden ist, wobei der erste Oberflächenabschnitt von der dielektrischen Isolationsschicht ausgebildet ist und der zweite Oberflächenabschnitt von dem Germanium-Substrat oder von einer III-V-Schicht ausgebildet ist.

## Beschreibung

Die Erfindung betrifft Stapelförmige Mehrfachsolarzelle mit einer ein Mehrschichtsystem umfassenden Metallisierung
Es sind unterschiedliche Verfahren zur Metallisierung von Halbleiterscheiben bekannt. Die gewünschte Metallstruktur wird beispielsweise mit Hilfe einer Lackmaske aus Positivlack oder aus Negativlack erzeugt, wobei das Metall flächig, z.B. mittels physikalischer Gasphasenabscheidung, aufgebracht wird. Alternativ werden Druckverfahren genutzt, z.B. Siebdruck oder Dispensköpfe, welche direkt nur die gewünschte Metallstruktur aufbringen.

Um die Abschattung der Vorderseite einer Solarzelle zu reduzieren, ist es möglich, die Vorderseite mittels einer Durchgangskontaktöffnung von der Rückseite zu kontaktieren. Solche Solarzellen werden auch als metal wrap through (MWT) - Solarzellen bezeichnet.

Neben unterschiedlichen Herstellungsverfahren der Durchgangskontaktöffnung sind auch unterschiedliche Metallisierungsverfahren bekannt, um insbesondere eine zuverlässige Metallisierung im Bereich der Durchgangskontaktöffnung zu erreichen.

Aus "Die Metal Wrap Through Solarzelle - Entwicklung und Charakterisierung", F. Clement, Dissertation, Februar 2009 ist Herstellungsverfahren für eine MWT-einfach-Solarzelle aus multikristallinem Silizium bekannt, wobei die Durchgangskontaktöffnungen mittels eines UV-Lasers oder eines IR-Lasers in einer mc Si-Substratschicht erzeugt werden. Erst anschließend wird mittels Phosphordiffusion entlang der Oberseite, der Seitenflächen der Durchgangskontaktöffnung und der Unterseite der Solarzelle eine Emitterschicht erzeugt.

Die Durchgangskontaktöffnung wird mit mittels Siebdrucks mit einer leitfähigen Via-Paste, z.B. einer Silberpaste, gefüllt.

Aus "III-V multi-junction metal-wrap-through (MWT) concentrator solar cells", E. Oliva et al., Proceedings, 32nd European PV Solar Energy Conference and Exhibition, München, 2016, pp. 1367-1371, ist eine invertiert gewachsene GaInP/AlGaAs Solarzellenstruktur mit Durchgangskontaktöffnungen bekannt, wobei die Solarzellenstruktur mit den pn-Übergängen epitaktisch gewachsen und ersten anschließend die Durchgangskontaktöffnungen mittels Trockenätzen erzeugt wird. Eine Seitenfläche der Durchgangsöffnung wird dann mit einer Isolationsschicht beschichtet und die Durchgangsöffnung wird anschließend mit galvanisiertem Kupfer gefüllt.

Aus der US 9,680,035 B1 ist ein Solarzellenstapel aus mehreren III-V-Teilzellen auf einem GaAs-Substrat mit rückseitenkontaktierter Vorderseite bekannt, wobei ein von der Oberseite der Solarzelle durch die Teilzellen bis in eine noch nicht gedünnte Substratschicht hinein reichendes Loch mittels eines nasschemischen Ätzprozesses erzeugt und erst durch Dünnen der Substratschicht nach unten geöffnet. Vor dem dünnen werden metallische Kontaktflächen auf der Solarzellenstapeloberseite angeordnet, die sich anschließenden Oberseite sowie die Seitenfläche des Lochs mit einer Isolationsschicht beschichtet und anschließend eine Metallschicht auf die metallischen Kontaktflächen und die Isolationsschicht aufgebracht.

Für eine gute Haftung einer Metallschicht auf einem Dielektrikum, z.B. auf Siliziumdioxid oder auf Siliziumnitrid, wird typischer Weise Titan eingesetzt. Wegen der schlechten Haftung wird Ti jedoch zur Kontaktierung von Ge und III-V Halbleiter eingesetzt. Eine zuverlässige und langlebige Haftung auf Halbleiterschichten aus Germanium oder III-V-Halbleitern wird beispielsweise Silber, Palladium oder Gold erreicht. Jedoch zeigen Edelmetalle wie Silber, Palladium oder Gold-eine ungenügende Haftung auf Dieletrika.

Vor diesem Hintergrund besteht die Aufgabe der Erfindung darin, eine Vorrichtung anzugeben, die den Stand der Technik weiterbildet.

Die Aufgabe wird durch eine Mehrfachsolarzelle mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige Mehrfachsolarzelle mit einer ein Mehrschichtsystem umfassenden Metallisierung bereitgestellt, wobei die Mehrfachsolarzelle ein eine Unterseite der Mehrfachsolarzelle ausbildendes Germanium-Substrat, eine Germanium-Teilzelle und mindestens zwei III-V-Teilzellen in der genannten Reihenfolge aufeinander folgend aufweist.

Das Mehrschichtsystem der Metallisierung weist eine Gold und Germanium umfassende erste Schicht mit einer Schichtdicke D1 von mindestens 2 nm und höchstens 50 nm, eine Titan umfassende zweite Schicht mit einer Dicke D2 von mindestens 10 nm und höchstens 300 nm, eine Palladium oder Nickel oder Platin umfassende dritte Schicht mit einer Schichtdicke D3 von mindestens 5 nm und höchstens 300 nm und mindestens eine metallische vierte Schicht mit einer Dicke D4 von mindestens 2 µm in der genannten Reihenfolge auf.

Das Mehrschichtsystem der Metallisierung bedeckt zumindest einen ersten Oberflächenabschnitt und einen zweiten Oberflächenabschnitt und ist sowohl mit dem ersten Oberflächenabschnitt als auch mit dem zweiten Oberflächenabschnitt stoffschlüssig verbunden, wobei der erste Oberflächenabschnitt von der dielektrischen Isolationsschicht ausgebildet ist und der zweite Oberflächenabschnitt von dem Germanium-Substrat oder von einer III-V-Schicht ausgebildet ist.

Es versteht sich, dass das Mehrschichtsystem, wie für Metallisierungen üblich, getempert, d.h. wärmebehandelt wird.

In einer Weiterbildung liegt die Temperatur bei der Wärmebehandlung des Mehrschichtmetallsystems vorzugsweise in einem Bereich zwischen 350° - 420°.

Vorzugsweise wird die Wärmebehandlung mit einer Lampenheizung d.h. mit einem sogenannten rapid thermal annealing (RTA) Prozess durchgeführt.

Insbesondere beträgt die Temperatur der Wärmebehandlung mindestens 350°C.

Hierdurch wird die eutektische Temperatur der Gold-Germanium-Schicht erreicht, wodurch eine Verbindung zwischen der Titan-Schicht mit der dielektrischen Schicht erst ermöglicht wird.

Es versteht sich weiterhin, dass die Schichten gemäß einer alternativen Ausführungsform jeweils auch aus den genannten Materialien bestehen, wobei der Begriff "bestehen" einschließt, dass weitere Stoffe, wie Verunreinigungen, ebenfalls noch umfasst bzw. enthalten sein können.

Außerdem versteht es sich, dass eine Ge-Teilzelle Germanium aufweist oder aus Germanium besteht, wobei auch eine aus Germanium bestehende Schicht gegebenenfalls zusätzlich zu dem Germanium noch weitere Stoffe, insbesondere Dotierstoffe, aber auch Verunreinigungen enthält.

Entsprechendes gilt auch für die III-V-Teilzellen, welche ein oder mehrere Materialien der III. sowie der V. Hauptgruppe aufweisen oder aus solchen Materialien bestehen.

Überraschenderweise hat sich gezeigt, dass das vorgeschlagene Schichtsystem sowohl auf einem Dielektrikum als auch auf einem Halbleiter sehr zuverlässig und langlebig haftet. Insbesondere die geringe Schichtdicke der Gold-Germanium-Schicht führt zu einer nicht homogen sondern zu einer Stellenweise Durchlässigkeit für die Ti- Schicht, was lokale Verbindungen zwischen der Titanschicht und der dielektrischen Isolationsschicht ermöglicht.

Andererseits reicht die geringe Schichtdicke der Gold-Germanium-Schicht aus, um einen zuverlässigen Stoffschluss der Gold-Germanium-Schicht mit der Ge-Schicht oder einer III-V-Teilzelle zu erreichen.

Das Mehrschichtsystem der Metallisierung eröffnet somit viele Möglichkeiten zur Optimierung des Herstellungsprozesses sowie hinsichtlich der Ausgestaltung der Metallisierung, insbesondere im Hinblick auf Durchgangskontaktierungen. Insbesondere können Prozessschritte, zusätzliche bzw. unterschiedliche Metallstrukturen, eingespart werden.

Daher stellt die erfindungsgemäße Mehrfachsolarzelle eine besonders kostengünstige und effiziente Lösung dar.

Gemäß einer ersten Ausführungsform weist die Mehrfachsolarzelle eine rückseitenkontaktierter Vorderseite auf, wobei die Halbleiterscheibe mindestens ein von einer Oberseite der Mehrfachsolarzelle durch die Teilzellen bis zu der Unterseite reichendes Durchgangskontaktloch mit zusammenhängender Seitenwand und einem im Querschnitt ovalen Umfang aufweist und eine Seitenwand des Durchgangskontaktlochs von einer dielektrischen Isolationsschicht bedeckt ist.

In einer andere Ausführungsform weist die vierte Schicht Silber umfasst und eine Schichtdicke von mindestens 2,5 µm und von höchstens 6 µm auf.

Gemäß einer weiteren Weiterbildung weist das Mehrschichtsystem eine Gold umfassende fünfte Schicht mit einer Schichtdicke D5 von mindestens 50 nm und höchstens 1 µm auf.

In einer anderen Weiterbildung besteht die dielektrische Schicht SiO₂ und/oder Si₃N₄ umfasst oder aus SiO₂ und/oder Si₃N₄.

Gemäß einer weiteren Ausführungsform umfasst die Mehrfachsolarzelle eine die Vorderseite ausbildende III-V-Deckschicht mit einer Dicke von 150 - 500 nm und einer Bandlücke von mindestens 1,86 eV umfasst. Die Deckschicht besteht beispielsweise aus InGaP oder umfasst InGaP.

In einer anderen Ausführungsform erstreckt sich das Mehrschichtsystem der Metallisierung von der Oberseite der Mehrfachsolarzelle entlang der Seitenwand durch das Durchgangskontaktloch bis zu der Unterseite der Mehrfachsolarzelle.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen, die
- Figur 1: einen Querschnitt einer erste erfindungsgemäße Ausführungsform einer stapelförmigen Mehrfachsolarzelle mit rückseitenkontaktierter Vorderseite und Mehrschichtsystem als Metallisierung,
- Figur 2: eine Rückseitenansicht einer erfindungsgemäßen Ausführungsform der Mehrfachsolarzelle,
- Figur 3: einen Querschnitt einer ersten erfindungsgemäßen Ausführungsform des Mehrschichtsystems der Metallisierung.

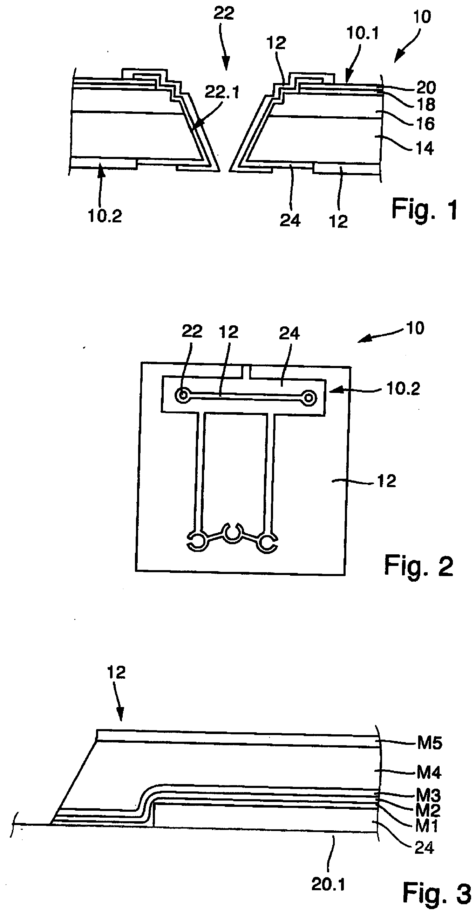

Die Abbildung der Figur 1 zeigt einen Ausschnitt einer stapelförmigen Mehrfachsolarzelle 10 mit einer ein Mehrschichtsystem 12 umfassenden Metallisierung und einer rückseitenkontaktierten Vorderseite in einem Querschnitt.

Die Mehrfachsolarzelle 10 weist eine Oberseite 10.1 und eine Unterseite 10.2 sowie eine von der Oberseite 10.1 bis zu der Unterseite 10.2 reichende Durchgangsöffnung 12 auf. Die Mehrfachsolarzelle 10 umfasst ein die Unterseite 10.1 ausbildendes Germanium-Substrat 14, eine auf das Germanium-Substrat folgende Germanium-Teilzelle 16, eine erste III-V-Teilzelle 18 und eine in dem dargestellten Ausführungsbeispiel die Oberseite 10.2 ausbildende zweite III-V-Teilzelle 20 in der genannten Reihenfolge.

Die Durchgangsöffnung 22 weist eine Seitenfläche 22.1 auf, wobei die Seitenfläche 22.1 wie eine Mantelfläche eines Zylinders zusammenhängend ausgebildet ist und in einem Querschnitt eine ovale Form, z.B. kreisförmig oder elliptisch, aufweist.

Die Seitenfläche 22.1 der Durchgangskontaktöffnung 22 sowie ein sich an die Durchgangsöffnung 22 anschließender Bereich der Oberseite 10.1 sowie der Unterseite 10.2 sind mit einer dielektrischen Isolationsschicht 24 bedeckt.

Auf der dielektrischen Isolationsschicht 24 ist das Mehrschichtsystem 12 der Metallisierung ausgebildet, wobei sich das Mehrschichtsystem 12 von einem an die dielektrische Isolationsschicht 24 angrenzenden Bereich der Oberseite 10.1 der Halbleiterscheibe 10 entlang der Seitenfläche 22.1 der Durchgangsöffnung 22 bis auf einen an die Durchgangsöffnung anschließenden Bereich der auf der Unterseite 10.2 ausgebildeten dielektrischen Isolationsschicht 24 erstreckt.

Das Mehrschichtsystem 12 reicht also auf der Oberseite 10.1 der Halbleiterscheibe 10 über die dielektrische Isolationsschicht 24 hinaus und ist sowohl mit der dielektrischen Isolationsschicht 24 als auch mit der Oberseite 10.1 der Halbleiterscheibe 10, hier also der zweiten III-V-Teilzelle 20 stoffschlüssig verbunden.

Ein nicht von der dielektrischen Isolationsschicht 24 bedeckter Teil der Unterseite 10.2 ist ebenfalls mit dem Mehrschichtsystem 12 der Metallisierung bedeckt.

In der Abbildung der Figur 2 ist eine Rückseitenansicht der Mehrfachsolarzelle gemäß der ersten Ausführungsform dargestellt. Im Folgenden werden nur die Unterschiede zu der Abbildung der Figur 1 erläutert.

Die Mehrfachsolarzelle 10 weist genau zwei Durchgangsöffnungen 22 auf. Die um die Durchgangsöffnungen 22 ausgebildeten Bereiche des Mehrschichtsystems 12 sind durch einen stegförmigen Abschnitt des Mehrschichtsystems 12 der Metallisierung verbunden und von der dielektrischen Isolationsschicht 24 umgeben.

Eine restliche Oberfläche der Unterseite 10.2 der Halbleiterscheibe ist flächig mit dem Mehrschichtsystem 12 bedeckt.

In der Abbildung der Figur 3 ist das Mehrschichtsystem gemäß einer ersten Ausführungsform detaillierter dargestellt. Im Folgenden werden nur die Unterschiede zu der Abbildung der Figur 1 erläutert.

Das Mehrschichtsystem 12 umfasst fünf Schichten. Eine Gold und Germanium umfassende erste Schicht M1 mit einer Schichtdicke von höchstens 50 nm bildet die unterste, an die dielektrische Schicht 24 und die Halbleiterscheibe 10 angrenzende Schicht aus.

Auf die erste Schicht M1 folgt eine Titan umfassende zweite Schicht M2 mit einer Schichtdicke von mindestens 10 nm. Eine dritte Schicht M3 umfasst Palladium oder Nickel oder Platin und weist eine Schichtdicke von mindestens 5 nm auf.

Eine beispielsweise Silber umfassende vierte metallische Schicht weist eine Schichtdicke von mindestens 2 µm auf. Als oberste Schicht umfasst das Mehrschichtsystem 12 in dem dargestellten Ausführungsbeispiel eine fünfte metallische Schicht, z.B. Gold umfassend, mit einer Schichtdicke von mindestens 50 nm.

## Patentansprüche

1. Stapelförmige Mehrfachsolarzelle (10) mit einer ein Mehrschichtsystem (12) umfassenden Metallisierung, wobei
- die Mehrfachsolarzelle (10) ein eine Unterseite (10.2) der Mehrfachsolarzelle (10) ausbildendes Germanium-Substrat (14), eine Germanium-Teilzelle (16) und mindestens zwei III-V-Teilzellen (18, 20) in der genannten Reihenfolge aufeinander folgend aufweist,
- das Mehrschichtsystem (12) der Metallisierung eine Gold und Germanium umfassende erste Schicht (M1) mit einer Schichtdicke D1 von mindestens 2 nm und höchstens 50 nm, eine Titan umfassende zweite Schicht (M2) mit einer Schichtdicke D2 von mindestens 10 nm und höchstens 300 nm, eine Palladium oder Nickel oder Platin umfassende dritte Schicht (M3) mit einer Schichtdicke D3 von mindestens 5 nm und höchstens 300 nm und mindestens eine metallische vierte Schicht (M4) mit einer Schichtdicke D4 von mindestens 2 µm in der genannten Reihenfolge aufweist und
- das Mehrschichtsystem (12) der Metallisierung zumindest einen ersten Oberflächenabschnitt und einen zweiten Oberflächenabschnitt bedeckt und sowohl mit dem ersten Oberflächenabschnitt als auch mit dem zweiten Oberflächenabschnitt stoffschlüssig verbunden ist, wobei
- der erste Oberflächenabschnitt von der dielektrischen Isolationsschicht (24) ausgebildet ist und der zweite Oberflächenabschnitt von dem Germanium-Substrat (14) oder von einer III-V-Schicht ausgebildet ist.

2. Stapelförmige Mehrfachsolarzelle (10) nach Anspruch 1, **dadurch gekennzeichnet, dass** die Mehrfachsolarzelle eine rückseitenkontaktierter Vorderseite aufweist, wobei
- die Halbleiterscheibe mindestens ein von einer Oberseite (10.1) der Mehrfachsolarzelle (10) durch die Teilzellen (16, 18, 20) bis zu der Unterseite (10.2) reichendes Durchgangskontaktloch (22) mit zusammenhängender Seitenwand (22.1) und einem im Querschnitt ovalen Umfang aufweist und
- eine Seitenwand (22.1) des Durchgangskontaktlochs (22) von einer dielektrischen Isolationsschicht (24) bedeckt ist.

3. Stapelförmige Mehrfachsolarzelle (10) nach Anspruch 1 oder 2, **dadurch gekennzeichnet, dass** die vierte Schicht (M4) Silber umfasst und eine Schichtdicke D4 von mindestens 2,5 µm und von höchstens 6 µm aufweist.

4. Stapelförmige Mehrfachsolarzelle (10) nach einem der vorstehenden Ansprüche, **dadurch gekennzeichnet, dass** das Mehrschichtsystem (12) eine Gold umfassende fünfte Schicht (M5) mit einer Schichtdicke D5 von mindestens 50 nm und höchstens 1 µm aufweist.

5. Stapelförmige Mehrfachsolarzelle (10) nach einem der vorstehenden Ansprüche, **dadurch gekennzeichnet, dass** die dielektrische Schicht (24) SiOₓ und/oder SiNₓ umfasst oder aus SiOₓ und/oder SiNₓ besteht.

6. Stapelförmige Mehrfachsolarzelle (10) nach einem der vorstehenden Ansprüche, **dadurch gekennzeichnet, dass** die dielektrische Schicht (24) eine a-Si-Schicht umfasst.

7. Stapelförmige Mehrfachsolarzelle (10) nach einem der vorstehenden Ansprüche, **dadurch gekennzeichnet, dass** die Mehrfachsolarzelle (10) eine die Vorderseite (10.1) ausbildende III-V-Deckschicht (30) mit einer Dicke von 150 - 500 nm und einer Bandlücke von mindestens 1,86 eV umfasst.

8. Stapelförmige Mehrfachsolarzelle (10) nach einem der vorstehenden Ansprüche, **dadurch gekennzeichnet, dass** sich das Mehrschichtsystem (12) der Metallisierung von der Oberseite (10.1) der Mehrfachsolarzelle (10) entlang der Seitenwand (22.1) durch das Durchgangskontaktloch (22) bis zu der Unterseite (10.2) der Mehrfachsolarzelle (10) erstreckt.
